# EUROPEAN PATENT APPLICATION

(11) **EP 3 734 491 A1**
(43) Date of publication of application: **04.11.2020**
(21) Application number: 19215147.0
(22) Date of filing: 11.12.2019
(51) Int. Cl.: G06F 30/367

(54) **METHOD, APPARATUS, DEVICE, AND MEDIUM FOR IMPLEMENTING SIMULATOR**

(30) Priority: 30.04.2019 CN 201910364810
(71) Applicant: Beijing Baidu Netcom Science And Technology Co., Ltd., Beijing 100085 (CN)
(72) Inventor: Zhang, Zhao, Beijing, Beijing 100085 (CN)
(74) Representative: V.O.

(57) **Abstract**

According to example embodiments of the present disclosure, a method, an apparatus, a device, and a medium for implementing a simulator are provided. The method includes reading a first piece of data for a first analog module of the simulator from a unified storage file, then writing a second piece of data into the unified storage file, the second piece of data being generated based on processing on the first piece of data by the first analog module. The method further includes reading the second piece of data for a second analog module in the simulator from the unified storage file, and then writing a third piece of data into the unified storage file, the third piece of data being generated based on processing on the second piece of data by the second analog module. Each analog module of the chip simulator according to some embodiments of the present disclosure exchanges data with the unified storage file without any data exchange between the modules, thereby facilitating any combination of the analog modules and adjusting the execution sequence of the analog modules, and improving the development efficiency of the chip simulator.

## Description

### TECHNICAL FIELD

Embodiments of the present disclosure generally relate to the field of simulator development, and more specifically to a method, apparatus, device, and computer readable storage medium for implementing a simulator.

### BACKGROUND

A simulator is generally a simulation program developed using software, and can simulate some specific hardware platforms. Examples of common simulators include computer simulators, driving simulators, flight simulators, and the like. A chip refers to a silicon wafer hardware containing an integrated circuit. In a chip development process, it is usually necessary to pre-develop or synchronously develop a function simulator corresponding to the chip. The function simulator mainly plays a role in validating the correctness of the chip hardware design, exploring the possibility of the hardware design scheme, whilst providing a software platform for developers and testing personnel, and accelerating the chip development, test and validation.

In order to achieve the goal of simulator development, it is necessary to keep consistent behaviors and capacities of the simulator and the chip as far as possible. In particular, the executing result and the function of the function simulator generally need to be identical to the executing result and the function of the chip. Generally, only accurate data can achieve chip validation and test, and play a role in absolute reference. However, in order to achieve an accurate function simulator with complete functions, the function simulator must be repeatedly corrected with the chip hardware, and the simulator itself needs to be repeatedly tested, thereby consuming a lot of manpower and time to complete the work. In addition, the function simulator needs to help in exploring the chip design scheme, thus facilitating the designers and the developers.

### SUMMARY

According to example embodiments of the present disclosure, a method, an apparatus, a device, and a computer readable storage medium for implementing a simulator are provided.

In a first aspect of the present disclosure, a method for implementing a simulator is provided. The method includes reading a first piece of data for a first analog module of the simulator from a unified storage file, the first analog module being configured for simulating a first function of a chip, and the unified storage file being configured for unified storage of input data and output data of analog modules in the simulator; writing a second piece of data into the unified storage file, the second piece of data being generated based on processing on the first piece of data by the first analog module; reading the second piece of data for a second analog module in the simulator from the unified storage file, the second analog module being configured for simulating a second function of the chip, and the second analog module being configured to run after the first analog module; and writing a third piece of data into the unified storage file, the third piece of data being generated based on processing on the second piece of data by the second analog module.

In a second aspect of the present disclosure, an apparatus for implementing a simulator is provided. The apparatus includes a first reading module configured to read a first piece of data of a first analog module for the simulator from a unified storage file, the first analog module being configured for simulating a first function of a chip, and the unified storage file being configured for unified storage of input data and output data of the analog module in the simulator; a first writing module configured to write a second piece of data into the unified storage file, the second piece of data being generated based on processing on the first piece of data by the first analog module; a second reading module configured to read the second piece of data for a second analog module in the simulator from the unified storage file, the second analog module being configured for simulating a second function of the chip, and the second analog module being configured to run after the first analog module; and a second writing module configured to write a third piece of data into the unified storage file, the third piece of data being generated based on processing on the second piece of data by the second analog module.

In a third aspect of the present disclosure, an electronic device is provided, including one or more processors; and a storage apparatus for storing one or more programs, when executed by the one or more processors, cause the one or more processors to implement the method or process according to the embodiments of the disclosure.

In a fourth aspect of the present disclosure, a computer readable storage medium is provided, storing a computer program thereon, where the program, when executed by a processor, implement the method or process according to the embodiments of the disclosure.

It should be understood that the content described in the summary section of the disclosure is not intended to limit the key or important features of the embodiments of the present disclosure, nor is it intended to limit the scope of the present disclosure. Other features of the present disclosure will become easily understood by the following description.

### BRIEF DESCRIPTION OF THE DRAWINGS

In conjunction with the accompanying drawings and with reference to detailed descriptions below, the above and other features, advantages, and aspects of various embodiments of the present disclosure will become more apparent. Identical or similar reference numerals in the accompanying drawings represent identical or similar elements.
Fig. 1 shows a schematic diagram of architecture of a conventional function simulator;
Fig. 2 shows a flowchart of a method for implementing a simulator according to an embodiment of the present disclosure;
Fig. 3 shows a schematic diagram of architecture of a function simulator for simulating a chip according to an embodiment of the present disclosure;
Fig. 4 shows a schematic diagram of architecture of another function simulator for simulating a chip according to an embodiment of the present disclosure;
Fig. 5 shows a schematic diagram for adjusting an execution sequence of analog modules in a function simulator according to an embodiment of the present disclosure;
Fig. 6 shows a schematic diagram of deleting an analog module and adding an analog module in the function simulator according to an embodiment of the present disclosure;
Fig. 7 shows a block diagram of an apparatus for implementing a simulator according to an embodiment of the present disclosure; and
Fig. 8 shows a block diagram of an electronic device capable of implementing some embodiments of the present disclosure.

### DETAILED DESCRIPTION OF EMBODIMENTS

Embodiments of the present disclosure will be described in more detail below with reference to the accompanying drawings. Some embodiments of the present disclosure are shown in the accompanying drawings. However, it should be understood that the present disclosure may be implemented by various approaches, and should not be construed as being limited to the embodiments set forth herein. On the contrary, these embodiments are provided to more thoroughly and completely understand the present disclosure. It should be understood that the accompanying drawings and embodiments of the present disclosure only play an exemplary role, and are not intended to limit the scope of protection of the present disclosure.

In the description of the embodiments of the present disclosure, the term "including" and similar wordings thereof should be construed as open-ended inclusions, i.e., "including but not limited to." The term "based on" should be construed as "at least partially based on." The term "an embodiment" or "the embodiment" should be construed as "at least one embodiment." The term "some embodiments" should be construed as "at least some embodiments." Other explicit and implicit definitions may be further included below.

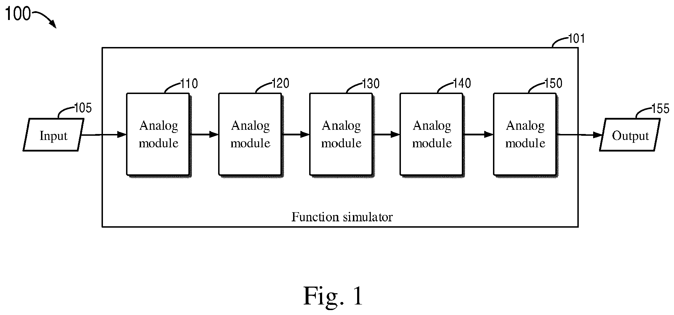

Fig. 1 shows a schematic diagram 100 of architecture of a conventional function simulator. As shown in Fig. 1, the function simulator 101 includes a plurality of analog modules 110, 120, 130, 140, and 150. These analog modules may each implement a function of a hardware chip. The function simulator 101 can obtain a corresponding output 155 by processing of each analog module based on a received input 105. A data flow sequence between these analog modules are usually fixed, and thus prior and following analog modules interacting with each analog module are defined in each analog module. For example, the analog module 120 receiving input data from the analog module 110 and being connected to the analog module 110 is defined in the analog module 120. In addition, the analog module 120 transferring output data to the analog module 130 and being connected to the analog module 130 further needs to be defined in the analog module 120. Thus, an input data module and an output data module connected to each analog module need to be defined in the analog module, and when an input data module and/or output data module of an analog module need to be adjusted, then the input data module and/or output data module in the analog module need to be re-defined.

Thus, in the development of a conventional simulator, the simulator is generally defined and developed based on specific design of chip hardware. For example, a function simulator corresponding to a chip has analog modules corresponding to function modules of the chip. Analog modules within the function simulator are closely connected via a programming interface of a software program, and the data flow sequence of each analog module is substantially fixed. Connection and data interaction between the analog modules are performed via program interfaces. However, such a close coupling design needs to modify a lot of analog modules during adding, deleting, and/or re-arranging the analog modules each time, resulting in low flexibility in function simulator development, complex adjustment, and low development efficiency. Thus, the existing technology has the problems of low development efficiency and poor expansibility of a chip simulator for simulating the hardware chip.

Thus, some embodiments of the present disclosure provide a fast modularized development scheme for the chip simulator. Each analog module of the chip simulator according to some embodiments of the present disclosure exchanges data with a unified storage file without data exchange between the modules, thereby facilitating any combination of the analog modules and adjusting an execution sequence of the analog modules, improving the development efficiency of the chip simulator, and further improving the expansibility of the chip simulator.

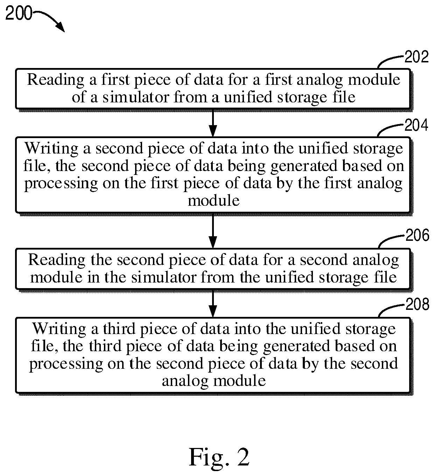

Further, the inventors also find that compared with an ordinary chip, an artificial intelligence (AI) chip is characterized by fast service support changes and flexible interface changes. The interface changes generally relate to changes of the related analog modules and data processing flow. In addition, a deep learning algorithm also changes fast, has many branches, and needs different function modules and specific data paths in different processing scenarios. Therefore, for the AI chip, a modularized function simulator is more desirable, and needs to reach the goal of flexible design and development. Thus, for an AI chip simulator, a layered and module-based decoupling design is more desirable, thus quickly supporting new change and design requirements. Example implementations of some embodiments of the present disclosure are described below with reference to Fig. 2-8.

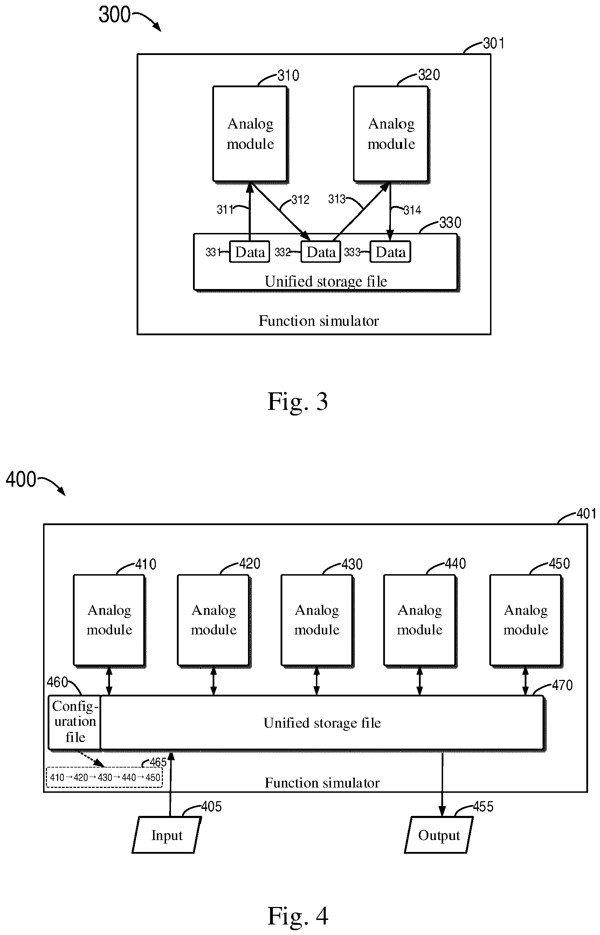

Fig. 2 is a flowchart of a method 200 for implementing a simulator according to an embodiment of the present disclosure. To facilitate describing the method 200 in Fig. 2, the method is described with reference to architecture of a function simulator for simulating a chip according to an embodiment of the present disclosure of Fig. 3.

Block 202: reading a first piece of data for a first analog module of a simulator from a unified storage file, the first analog module being configured for simulating a first function of a chip, the unified storage file being configured for unified storage of input data and output data of analog modules in the simulator. For example, Fig. 3 shows a schematic diagram 300 of architecture of a function simulator 301 for simulating a chip according to an embodiment of the present disclosure. As shown by an arrow 311, an analog module 310 reads data 331 from a unified storage file 330, where the analog module 310 can simulate a function of the chip, such as matrix computing. In some embodiments of the present disclosure, the unified storage file 330 can unifiedly store input and output data of the analog modules, thus providing a unified data exchange interface for the analog modules, thereby avoiding direct data exchange between the analog modules. In some embodiments, the data 331 may be an external input of the function simulator 301. Alternatively, the data 331 may be an output result generated by other analog modules (not shown) of the function simulator 301.

Block 204: writing a second piece of data into the unified storage file, the second piece of data being generated based on processing on the first piece of data by the first analog module. For example, with reference to Fig. 3, the analog module 310 processes the data 331 (e.g., matrix computing), generates data 332, and sends the data 332 to the unified storage file 330, as shown by an arrow 312.

Block 206: reading the second piece of data for a second analog module in the simulator from the unified storage file, the second analog module being configured for simulating a second function of the chip, and the second analog module being configured to run after the first analog module. For example, with reference to Fig. 3, as shown by an arrow 313, an analog module 320 reads the data 332 from the unified storage file 330, where the analog module may alternatively simulate a function of the chip, such as activation computing. Since the analog module 320 is pre-configured to be executed after the analog module 310, the input data 332 read by the analog module 320 is an output result (i.e., output data) of the analog module 310. Further, it should be understood that the first analog module and the second analog module may simulate various functions of a hardware chip, respectively.

Block 208: writing a third piece of data into the unified storage file, the third piece of data being generated based on processing on the second piece of data by the second analog module. For example, with reference to Fig. 3, the analog module 320 processes the data 332 (e.g., activation computing), generates data 333, and then sends the data 333 to the unified storage file 330, as shown by an arrow 314.

Therefore, each analog module of the chip simulator of the method 200 according to some embodiments of the present disclosure exchanges data with the unified storage file without direct data interaction between the analog modules. In this way, each analog module of the chip simulator is only concerned about how to exchange data with the unified storage file, thereby facilitating subsequent any combination of modules and adjusting an execution sequence of the modules, and improving the development efficiency and expansibility of the chip simulator.

Further, in some embodiments according to the present disclosure, after completing computing the data 331, the analog module 310 transfers a computing result to the unified storage file 330, rather than directly transferring the computing result to the next analog module 320. In some embodiments, when writing the data 332 into the unified storage file 330, information, such as type, position, and size, of the data 332 may be recorded in the unified storage file 330.

In some embodiments of the present disclosure, each analog module of the function simulator has data processing capacities, including data collation, data computing, data transfer, and the like. After data processing, each analog module writes the result into the unified storage file, and indicates the information, such as the type of the data, the position of the data, and the size of the data. When needing to read data, other analog modules all read the data from the unified storage file, analyze the data based on data configuration information of the unified storage files, acquire the data to their own function modules for operations, write the computing result back into the unified storage file, and mark the information, such as the type of the data, the position of the data, and the size of the data. In this way, there is no program interaction between the analog modules. Each analog module is connected to a data storage file, and is isolated from a relationship with other analog modules.

By the above approach, each analog module may be independent of other analog modules, and is only concerned about data analysis and reading of the unified storage file. The analog module reads concerned data from the unified storage file, then computes and processes the data, and then writes the result back into the unified storage file, for subsequent re-use by the analog module. Each analog module is developed and tested with only one unified storage file as an interface, only needs to be concerned about internal program development and debugging within its own module, and subsequently may be adjusted and cooperate with any analog module in logical sequence.

The inventors of the present disclosure realize that the current AI chip design is somewhat different from the conventional general-purpose chip. An AI chip is closer to actual algorithms and software applications, and is not designed for general-purpose computing and processing. Therefore, the AI chip needs to be specific to actual service scenarios, to solve the problems of specific algorithm acceleration and application acceleration. AI chip design and requirements must be accompanied by actual service development, algorithm evolution, and market demand, thus achieving the purpose of serving the applications. In the process of constantly changing and iterating software algorithms, an underlying AI chip needs to make a quick design and validation method for evaluation and design. In this case, the design and validation are often achieved through an AI chip function simulator, because the hardware development cycle is long, and a software function simulator is required to perform rapid development and validate the scheme feasibility and the design scheme correctness. This requires that the software function simulator must also be fast and flexibly implemented to support the actual service scenarios.

The computing sequence of the analog modules of the method according to some embodiments of the present disclosure may be combined in any way, and thus can better match the design and simulation demand of the AI chip. AI algorithms are quickly changing and iterating, and the sequence and computing relationship of the analog modules of the algorithms may also flexibly change. Some embodiments of the present disclosure may provide analog modules of function simulators discretionarily, and adjust an execution sequence of the function simulators, to meet the changes of upper layer applications. In this process, the function simulator according to some embodiments of the present disclosure hardly needs to change, thereby significantly reducing the development and debugging workloads, and can help the AI chip to quickly validate the design feasibility.

In some embodiments, a chip simulated in some embodiments of the present disclosure may be an AI chip for executing an accelerated computing task, and the AI chip may include various computing modules, such as a data collating module, a matrix computing module, an activation computing module, and a direct memory access (DMA) module. In this way, the AI chip design feasibility may be validated using the function simulator of some embodiments of the present disclosure, thereby effectively solving the demands for AI chip design validation.

Fig. 4 shows a schematic diagram 400 of architecture of another function simulator 401 for simulating a chip according to an embodiment of the present disclosure. As shown in Fig. 4, the function simulator 401 includes a plurality of analog modules 410, 420, 430, 440, and 450, a control flow configuration file 460, and a unified storage file 470, where each analog module is configured for simulating a function of the chip (e.g., an AI chip).

Referring to Fig. 4, the control flow configuration file 460 is used for configuring an execution sequence between the plurality of analog modules in the simulator, such as an execution sequence 465, which indicates an execution process of the analog modules in the function simulator 401 after starting the function simulator 401, the execution process including: first executing the analog module 410, then executing the analog module 420, then executing the analog module 430, then executing the analog module 440, and then executing the analog module 450. That is, the function simulator 401 sequentially executes the plurality of analog modules based on an execution sequence configured in the control flow configuration file 460. The unified storage file 470 can unifiedly store input and output data of the analog modules, thus providing a unified data exchange interface for the analog modules, thereby avoiding data exchange between the analog modules. Thus, in the process of executing each analog module, data is read from the unified storage file 470, and a processing result is unifiedly written into the unified storage file 470, until computing all computing processes.

Further referring to Fig. 4, the function simulator receives an external input 405, stores or caches the input into the unified storage file 470, and then based on the execution sequence 465, the analog module 410 first reads data from the unified storage file 470, and then writes a corresponding result into the unified storage file 470 after completing processing. In sequence, the analog module 420 reads data from the unified storage file 470, and then writes an executing result into the unified storage file; the analog module 430 reads data from the unified storage file 470, and then writes an executing result into the unified storage file; the analog module 440 reads data from the unified storage file 470, and then writes an executing result into the unified storage file; and the analog module 450 reads data from the unified storage file 470, and then writes an executing result into the unified storage file. After all of the analog modules complete processing, final data are outputted from the unified storage file 470 to the outside, for use as an output 455.

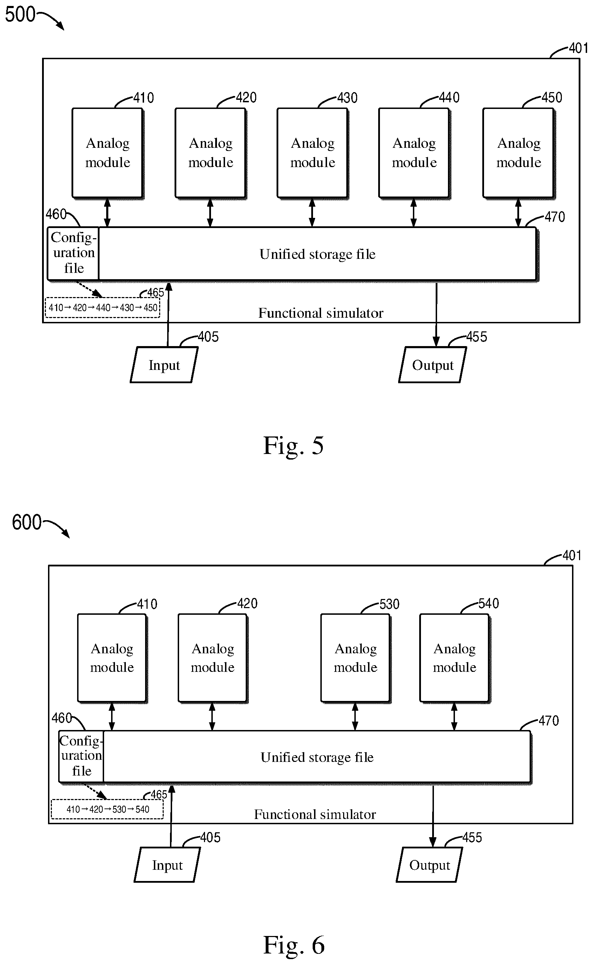

Fig. 5 shows a schematic diagram 500 for adjusting an execution sequence of analog modules according to an embodiment of the present disclosure. For example, an execution sequence in the control flow configuration file may be modified, and then processing flow of a plurality of analog modules in the simulator is adjusted based on the modified execution sequence. As shown in Fig. 5, when an execution sequence of the analog module 430 and the analog module 440 is inverted to test a new design, it is only necessary to modify the execution sequence 465 in the control flow configuration file 460. Then, the function simulator 401, when running, executes the modified processing flow based on the modified execution sequence 465. Thus, according to some embodiments of the present disclosure, when it is necessary to adjust the execution sequence of the analog modules in the function simulator 401, the execution sequence of the modules in the function simulator 401 can be changed discretionarily only by setting via the control flow configuration file 460 without modifying a code or interface connection of the analog modules themselves, thereby significantly improving the development efficiency of the chip simulator.

Alternatively or additionally, the execution sequence may also be modified in the control flow configuration file when an analog module is deleted and/or added in the function simulator. Fig. 6 shows a schematic diagram 600 of deleting an analog module and adding an analog module according to an embodiment of the present disclosure. As shown in Fig. 6, compared with Fig. 4 and Fig. 5, the analog modules 430, 440 and 450 in the function simulator 401 are deleted, whilst new analog modules 530 and 540 (e.g., new analog modules having a new simulating function) are added. Accordingly, the execution sequence 465 in the control flow configuration file 460 is modified. Then, the function simulator 401 executes the analog processing procedure based on the updated and modified execution sequence 465. That is, the analog module 410 is first executed, then the analog module 420 is executed, then the analog module 530 is executed, and then the analog module 540 is executed.

According to some embodiments of the present disclosure, a developer of the analog modules of the function simulator only needs to pay attention to development and debugging of its own internal modules, each analog module may be independent of other analog modules, and the developer only needs to be concerned about data analysis and reading of the unified storage file. Each analog module reads desired data from the unified storage file, then computes and processes the data, and writes the result back into the unified storage file for subsequent use by other analog modules. An architecture designer of the function simulator may discretionarily build the overall frame of the simulator, and adjust the computing path and data processing flow. That is, the architecture designer may discretionarily arrange (such as add, replace or delete) the analog modules and try various ways and combinations of the analog modules, without the need for modifying a program code of each analog module. This design approach can effectively reduce development and debugging workloads of the function simulator, and accelerate the design and validation of the whole chip (e.g., an AI chip).

In some embodiments, a permission of each analog module in the simulator to read data from and write data into the unified storage file may also be configured in the control flow configuration file. This approach may cause each analog module to read only a portion of data, while failing to read or operate other data, thus ensuring the safety and reliability of the simulator.

Therefore, in the method according to some embodiments of the present disclosure, the execution sequence of the analog modules may be combined in any way, to better match the design and exploration of the AI chip. AI algorithms are quickly changing and iterating, and the sequence and computing relationship of the analog modules of the algorithms may also flexibly change. Modules of each function simulator may be configured discretionarily, and the execution sequence of the function simulators may be adjusted, to meet the changes of upper layer applications. In this process, the function simulator according to some embodiments of the present disclosure only needs very few changes, thereby significantly reducing the development and debugging workloads, and can help the AI chip to quickly validate the design feasibility.

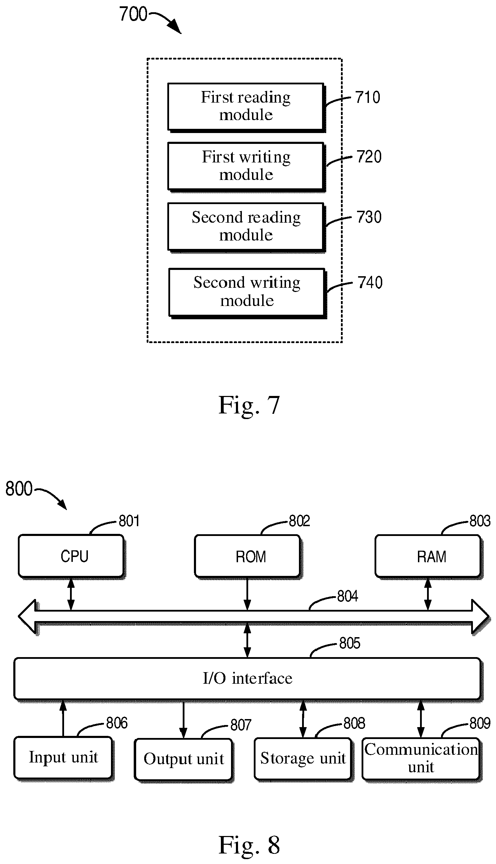

Fig. 7 shows a block diagram of an apparatus 700 for implementing a simulator according to an embodiment of the present disclosure. As shown in Fig. 7, the apparatus 700 includes a first reading module 710, a first writing module 720, a second reading module 730, and a second writing module 740. The first reading module 710 is configured to read a first piece of data for a first analog module of a simulator from a unified storage file, the first analog module being configured for simulating a first function of a chip, and the unified storage file being configured for unified storage of input data and output data of each analog module in the simulator. The first writing module 720 is configured to write a second piece of data into the unified storage file, the second piece of data being generated based on processing on the first piece of data by the first analog module. The second reading module 730 is configured to read the second piece of data for a second analog module in the simulator from the unified storage file, the second analog module being configured for simulating a second function of the chip, and the second analog module being configured to run after the first analog module. The second writing module 740 is configured to write a third piece of data into the unified storage file, the third piece of data being generated based on processing on the second piece of data by the second analog module.

In some embodiments, the chip may be an artificial intelligence (AI) chip for executing an accelerated computing task, and the first analog module and the second analog module each are any one of the following items: a data collating module, a matrix computing module, an activation computing module, or a direct memory access (DMA) module. The apparatus 700 may further include a validating module configured to validate design feasibility of the artificial intelligence chip using the simulator.

In some embodiments, the apparatus 700 further includes: a configuring module configured to configure an execution sequence between a plurality of analog modules in the simulator in a control flow configuration file, the plurality of analog modules at least including the first analog module and the second analog module; and an executing module configured to sequentially execute the plurality of analog modules based on the execution sequence configured in the control flow configuration file.

In some embodiments, the apparatus 700 further includes: a modifying module configured to modify the execution sequence in the control flow configuration file; and an adjusting module configured to adjust processing flow of the plurality of analog modules in the simulator based on the modified execution sequence.

In some embodiments, the modifying module includes: a second modifying module configured to modify, in response to reconfiguring one or more analog modules in the simulator, the execution sequence in the control flow configuration file, the reconfiguring one or more analog modules including at least one of adding, deleting, or rearranging the one or more analog modules.

In some embodiments, the apparatus 700 further includes: a second configuring module configured to configure a permission of each analog module in the simulator to read data from and write data into the unified storage file in the control flow configuration file.

In some embodiments, the first writing module 710 includes: a transferring module configured to transfer the second piece of data from the first analog module to the unified storage file, rather than directly sending the second piece of data from the first analog module to the second analog module; and a recording module configured to record type, position and size of the second piece of data in the unified storage file.

In some embodiments, the apparatus 700 further includes: a third reading module configured to read the third piece of data for a third analog module in the simulator from the unified storage file, the third analog module being configured for simulating a third function of the chip; and a third writing module configured to write a fourth piece of data into the unified storage file, the fourth piece of data being generated based on processing on the third piece of data by the third analog module.

It should be understood that the first reading module 710, the first writing module 720, the second reading module 730, and the second writing module 740 shown in Fig. 7 may be included in one or more electronic devices. Further, it should be understood that the modules shown in Fig. 7 may execute the steps or actions in the method or process with reference to some embodiments of the present disclosure. Therefore, in the process of developing the chip simulator of some embodiments of the present disclosure, each analog module exchanges data with the unified storage file without any data exchange between the modules, thereby facilitating any combination of the modules and adjusting the execution sequence of the modules, and improving the development efficiency of the chip simulator.

Fig. 8 shows a schematic block diagram of an example device 800 that may be configured to implement some embodiments of the present disclosure. It should be understood that the device 800 may be configured to implement the apparatus 700 or electronic device for implementing the simulator according to the embodiments of the present disclosure. As shown in the figure, the device 800 includes a central processing unit (CPU) 801, which may execute various appropriate actions and processes in accordance with computer program instructions stored in a read-only memory (ROM) 802 or computer program instructions loaded into a random access memory (RAM) 803 from a storage unit 808. The RAM 803 may further store various programs and data required by operations of the device 800. The CPU 801, the ROM 802, and the RAM 803 are connected to each other through a bus 804. An input/output (I/O) interface 805 is also connected to the bus 804.

A plurality of components in the device 800 is connected to the I/O interface 805, including: an input unit 806, such as a keyboard, and a mouse; an output unit 807, such as various types of displays and speakers; a storage unit 808, such as a magnetic disk, and an optical disk; and a communication unit 809, such as a network card, a modem, and a wireless communication transceiver. The communication unit 809 allows the device 800 to exchange information/data with other devices via a computer network, e.g., the Internet, and/or various telecommunication networks.

The processing unit 801 executes various methods and processes described above, such as the method 200. For example, in some embodiments, the method may be implemented in a computer software program that is tangibly included in a machine readable medium, such as the storage unit 808. In some embodiments, a part or all of the computer program may be loaded and/or installed onto the device 800 via the ROM 802 and/or the communication unit 809. When the computer program is loaded into the RAM 803 and executed by the CPU 801, one or more actions or steps of the method escribed above may be executed. Alternatively, in other embodiments, the CPU 801 may be configured to execute the method by any other appropriate approach (e.g., by means of firmware).

The functions described herein above may be performed, at least in part, by one or more hardware logic components. For example, and without limitation, exemplary types of hardware logic components that may be used include: Field Programmable Gate Array (FPGA), Application Specific Integrated Circuit (ASIC), Application Specific Standard Product (ASSP), System on Chip (SOC), Complex Programmable Logic Device (CPLD), and the like.

Program codes for implementing the method of the present disclosure may be written in any combination of one or more programming languages. These program codes may be provided to a processor or controller of a general purpose computer, special purpose computer or other programmable data processing apparatus such that the program codes, when executed by the processor or controller, enables the functions/operations specified in the flowcharts and/or block diagrams being implemented. The program codes may execute entirely on the machine, partly on the machine, as a stand-alone software package partly on the machine and partly on the remote machine, or entirely on the remote machine or server.

In the context of the present disclosure, the machine readable medium may be a tangible medium that may contain or store programs for use by or in connection with an instruction execution system, apparatus, or device. The machine readable medium may be a machine readable signal medium or a machine readable storage medium. The machine readable medium may include, but is not limited to, an electronic, magnetic, optical, electromagnetic, infrared, or semiconductor system, apparatus, or device, or any suitable combination of the foregoing. More specific examples of the machine readable storage medium may include an electrical connection based on one or more wires, portable computer disk, hard disk, random access memory (RAM), read only memory (ROM), erasable programmable read only memory (EPROM or flash memory), optical fiber, portable compact disk read only memory (CD-ROM), optical storage device, magnetic storage device, or any suitable combination of the foregoing.

In addition, although various operations are described in a specific order, this should not be understood that such operations are required to be performed in the specific order shown or in sequential order, or all illustrated operations should be performed to achieve the desired result. Multitasking and parallel processing may be advantageous in certain circumstances. Likewise, although several specific implementation details are included in the above discussion, these should not be construed as limiting the scope of the present disclosure. Certain features described in the context of separate embodiments may also be implemented in combination in a single implementation. Conversely, various features described in the context of a single implementation may also be implemented in a plurality of implementations, either individually or in any suitable sub-combination.

Although the embodiments of the present disclosure are described in language specific to structural features and/or method logic actions, it should be understood that the subject matter defined in the appended claims is not limited to the specific features or actions described above. Instead, the specific features and actions described above are merely exemplary forms of implementing the claims.

## Claims

1. A method for implementing a simulator, comprising:
reading (202) a first piece of data for a first analog module of the simulator from a unified storage file, the first analog module being configured for simulating a first function of a chip, and the unified storage file being configured for unified storage of input data and output data of analog modules in the simulator;
writing (204) a second piece of data into the unified storage file, the second piece of data being generated based on processing on the first piece of data by the first analog module;
reading (206) the second piece of data for a second analog module in the simulator from the unified storage file, the second analog module being configured for simulating a second function of the chip, and the second analog module being configured to run after the first analog module; and
writing (208) a third piece of data into the unified storage file, the third piece of data being generated based on processing on the second piece of data by the second analog module.

2. The method according to claim 1, wherein the chip is an artificial intelligence (AI) chip for executing an accelerated computing task, and the first analog module and the second analog module each are any one of following items: a data collating module, a matrix computing module, an activation computing module, or a direct memory access (DMA) module, and the method further comprises:
validating design feasibility of the artificial intelligence chip using the simulator.

3. The method according to claim 1 or 2, wherein the method further comprises:
configuring an execution sequence between a plurality of analog modules in the simulator in a control flow configuration file, the plurality of analog modules at least comprising the first analog module and the second analog module; and
sequentially executing the plurality of analog modules based on the execution sequence configured in the control flow configuration file.

4. The method according to claim 3, wherein the method further comprises:
modifying the execution sequence in the control flow configuration file; and
adjusting processing flow of the plurality of analog modules in the simulator based on the modified execution sequence, wherein the modifying the execution sequence in the control flow configuration file preferably comprises:
modifying, in response to reconfiguring one or more analog modules in the simulator, the execution sequence in the control flow configuration file, the reconfiguring one or more analog modules comprising at least one of adding, deleting, or rearranging the one or more analog modules.

5. The method according to claim 3, wherein the method further comprises:
configuring a permission of each analog module in the simulator to read data from and write data into the unified storage file in the control flow configuration file.

6. The method according to any one of claim 1 to 5, wherein the writing a second piece of data into the unified storage file comprises:
transferring the second piece of data from the first analog module to the unified storage file, rather than directly sending the second piece of data from the first analog module to the second analog module; and
recording type, position and size of the second piece of data in the unified storage file.

7. The method according to any one of claims 1 to 6, wherein the method further comprises:
reading the third piece of data for a third analog module in the simulator from the unified storage file, the third analog module being configured for simulating a third function of the chip; and
writing a fourth piece of data into the unified storage file, the fourth piece of data being generated based on processing on the third piece of data by the third analog module.

8. An apparatus for implementing a simulator, comprising:
a first reading module (710) configured to read a first piece of data of a first analog module for the simulator from a unified storage file, the first analog module being configured for simulating a first function of a chip, and the unified storage file being configured for unified storage of input data and output data of the analog module in the simulator;
a first writing module (720) configured to write a second piece of data into the unified storage file, the second piece of data being generated based on processing on the first piece of data by the first analog module;
a second reading module (730) configured to read the second piece of data for a second analog module in the simulator from the unified storage file, the second analog module being configured for simulating a second function of the chip, and the second analog module being configured to run after the first analog module; and
a second writing module (740) configured to write a third piece of data into the unified storage file, the third piece of data being generated based on processing on the second piece of data by the second analog module.

9. The apparatus according to claim 8, wherein the chip is an artificial intelligence (AI) chip for executing an accelerated computing task, and the first analog module and the second analog module each are any one of following items: a data collating module, a matrix computing module, an activation computing module, or a direct memory access (DMA) module, and the apparatus further comprises:
a validating module configured to validate design feasibility of the artificial intelligence chip using the simulator.

10. The apparatus according to claim 8 or 9, wherein the apparatus further comprises:
a configuring module configured to configure an execution sequence between a plurality of analog modules in the simulator in a control flow configuration file, the plurality of analog modules at least comprising the first analog module and the second analog module; and
an executing module configured to sequentially execute the plurality of analog modules based on the execution sequence configured in the control flow configuration file.

11. The apparatus according to claim 10, wherein the apparatus further comprises:
a modifying module configured to modify the execution sequence in the control flow configuration file; and
an adjusting module configured to adjust processing flow of the plurality of analog modules in the simulator based on the modified execution sequence, wherein the modifying module preferably comprises:
a second modifying module configured to modify, in response to reconfiguring one or more analog modules in the simulator, the execution sequence in the control flow configuration file, the reconfiguring one or more analog modules comprising at least one of adding, deleting, or rearranging the one or more analog modules.

12. The apparatus according to claim 10, wherein the apparatus further comprises:
a second configuring module configured to configure a permission of each analog module in the simulator to read data from and write data into the unified storage file in the control flow configuration file.

13. The apparatus according to any one of claims 8 to 12, wherein the first writing module comprises:
a transferring module configured to transfer the second piece of data from the first analog module to the unified storage file, rather than directly sending the second piece of data from the first analog module to the second analog module; and
a recording module configured to record type, position and size of the second piece of data in the unified storage file.

14. The apparatus according to any one of claims 8 to 13, wherein the apparatus further comprises:
a third reading module configured to read the third piece of data for a third analog module in the simulator from the unified storage file, the third analog module being configured for simulating a third function of the chip; and
a third writing module configured to write a fourth piece of data into the unified storage file, the fourth piece of data being generated based on processing on the third piece of data by the third analog module.

15. A computer readable storage medium, storing a computer program thereon, wherein the program, when executed by a processor, implements the method according to any one of claims 1-7.
